# EUROPÄISCHE PATENTANMELDUNG

(11) **EP 2 434 328 A1**
(43) Veröffentlichungstag der Anmeldung: **28.03.2012**
(21) Anmeldenummer: 11007822.7
(22) Anmeldetag: 26.09.2011
(51) Int. Cl.: G02B 26/08, G03F 7/20, G02B 27/14

(54) **Belichtungsanordnung**

(30) Priorität: 24.09.2010 DE 102010046395
(71) Anmelder: Printprocess AG, 6300 Zug (CH)
(72) Erfinder: Maurer, Hartmut, 6312 Steinhausen (CH); Pagan, Robin, 70563 Stuttgart-Vaihingen (DE)
(74) Vertreter: Schneider, Peter Christian

(57) **Zusammenfassung**

Belichtungsanordnung für eine Vorrichtung zur digitalen Direktbelichtung insbesondere von elektronischen Leiterplatten mit einer Leuchte, deren Strahlen von einer Linse gesammelt und einem vorgelagerten räumlichen Lichtmodulator zum Reflektieren von Lichtstrahlen der Leuchte in einem vorbestimmten Muster zugeführt werden, wobei die Leuchte von mindestens zwei Lichtquellen, die als UV-Leuchtdioden ausgebildet sind und unterschiedliche nahe beieinander liegende Wellenlängen aufweisen, gebildet wird, wobei die Wellenlängen benachbarter Lichtquellen mindestens einen Wellenlängenunterschied von 2% aufweisen, wobei die mindestens zwei Lichtquellenmit jeweils vorgelagerter Sammellinse ausgebildet sind, deren Lichtstrahlen über einen Beam-Combiner zu einem gemeinsamen Strahlenbündel verbunden und dem Lichtmodulator zugeführt werden.

## Beschreibung

### Gebiet der Erfindung

Die Erfindung betrifft eine Belichtungsanordnung für eine Vorrichtung zur digitalen Direktbelichtung von elektronischen Leiterplatten mit einer Leuchte, deren Strahlen von einer Linse gesammelt und einem vorgelagerten räumlichen Lichtmodulator zum Reflektieren von Lichtstrahlen der Leuchte in einem vorbestimmten Muster zugeführt werden

### Stand der Technik

Für digitale Direktbelichter, wie sie für die Herstellung von elektronischen Leiterplatten oder für die photochemische Bearbeitung von Metallen verwendet werden, werden Laser, Laserdioden oder Kurzbogenlampen als Lichtquellen eingesetzt.

Der Nachteil dabei ist, dass sie zum einen sehr viel Strom verbrauchen und durch die hohe Abwärme auch eine erhebliche Kühlleistung benötigen. Zum anderen ist die Lebensdauer in diesen Lichtquellen relativ kurz und die Ersatzkosten sind relativ hoch.

Für photolithographische bzw. photochemische Belichtung werden im UV-Bereich liegende Lichtwellenlängen benötigt. Zwar kommt der Einsatz einer UV-Leuchtdiode (UV-LED) in Frage, jedoch weisen auch die modernen Hochleistungs-UV-Dioden als Lichtquelle eine zu geringe Leistung auf.

Aus der EP 1 363 166 A2 ist eine Belichtungsanordnung für eine Vorrichtung zur digitalen Direktbelichtung zum Schreiben von Mustern auf einem photosensitiven Material bekannt. Dabei werden die Strahlen einer Leuchte bzw. Lichtquelle von einer Linse gesammelt und einem vorgelagerten räumlichen Lichtmodulator einem Digital Micromirror Device (DMD), also einem Lichtmodular, der eine Gruppe von Mikrospiegeln aufweist, zum Reflektieren von Lichtstrahlen der Leuchte bzw. der Lichtquelle in einem vorbestimmten Muster zugeführt werden.

Ein entsprechendes Belichtungs- und Lichtmodulationssystem ist im Wesentlichen auch aus der DE 41 21 509 A1 bekannt.

Diese bekannten Belichtungs- und Lichtmodulationssysteme weisen die oben geschilderten Nachteile auf.

Aus der US 2003/0147144 A1 ist eine Vorrichtung zur digitalen Direktbelichtung zur Erzeugung von farbigen Laufbildern bekannt. Die Vorrichtung weist eine Leuchte mit drei LED-Lichtquellen unterschiedlicher Wellenlänge, nämlich Rot, Gelb Grün, auf, deren Lichtbündel mittels eines dichroitischen Prismas, das einen Beam-Combiner bildet, zu einem Gesamtlichtbündel zusammengeführt und einem reflektiven Lichtmodulator zugeführt werden.

Nachteilig dabei ist, dass die Zusammenführung mehrerer (gleicher) UV-Leuchtdioden mit einem Beam-Combiner praktisch zu keiner Leistungssteigerung führt.

Weiterhin ist aus der US 2005/0157269 ist ein Lichtprojektor zur Erzeugung von farbigen Bildern bekannt, der ebenfalls die Lichtbündel dreier LED-Lichtquellen der Wellenlängen Rot, Gelb und Grün zu einem gemeinsamen Lichtbündel über dichroitische Prismen zusammenführt.

### Aufgabenstellung

Aufgabe der vorliegenden Erfindung ist es daher, eine Belichtungsanordnung anzugeben, bei der kostengünstige UV-Lichtquellen mit langer Lebensdauer bei gesteigerter Lichtleistung eingesetzt werden können.

### Darstellung der Erfindung

Diese Aufgabe wird in Verbindung mit dem Oberbegriff des Anspruches 1 dadurch gelöst, dass die Leuchte von mindestens zwei Lichtquellen, die als UV-Leuchtdioden ausgebildet sind und unterschiedliche nahe beieinander liegende Wellenlängen aufweisen, gebildet wird, dass die Wellenlängen benachbarter Lichtquellen mindestens einen Wellenlängenunterschied von 2% aufweisen, dass die mindestens zwei Lichtquellenmit jeweils vorgelagerter Sammellinse ausgebildet sind, deren Lichtstrahlen über mindestens einen Beam-Combiner zu einem gemeinsamen Strahlenbündel verbunden und dem Lichtmodulator zugeführt werden.

Erst durch die Verwendung unterschiedlicher, wenn auch nahe beieinander liegenden Wellenlängen, wird es möglich, die Lichtstrahlen mehrerer Lichtquellen mittels eines Beam-Combiners, der als ein dichroitischer Spiegel (dichroid mirror) ausgebildet ist, in einem Lichtstrahl leistungsstärkend zu kombinieren. Dadurch wird zum einen die Lichtleistung erheblich erhöht und zum anderen ein "Wellenlängen-Mix" geschaffen, der die an Leiterplatten verwendeten photosensitiven Trockenfilme und Lacke, welche auf unterschiedliche UV-Wellenlängen reagieren, optimal mit dem richtigen UV-Licht belichtet. Dabei wird die Étendu (Lichtleitwert) des optischen Systems nicht verändert, dieses ist von zentraler Bedeutung, wenn es darum geht, mehrere Lichtquellen zu bündeln, da alle anderen Lichtadditionsmöglichkeiten den Abstrahlwinkel der Lichtquelle vergrößern, welches dazu führt, dass letztlich keine Verbesserung am Ausgang des optischen Systems erzielt werden würde.

Gemäß einer bevorzugten Ausführungsform der Erfindung bilden die UV-Leuchtdiode (LED) und die Sammellinse zusammen mit einem Gehäuse jeweils einen separaten Leuchtenkopf. Die Leuchtenköpfe sind dabei Flüssigkeitsgekühlt ausgebildet. Durch den Einsatz einer flüssigkeits- bzw. Wasserkühlung können die Leuchtdioden in einer optimalen Betriebstemperatur konstant gehalten werden.

Nach einer weiteren bevorzugten Ausführungsform der Erfindung wird die Leuchte von mindestens drei Lichtquellen unterschiedlicher Wellenlänge gebildet. Bevorzugt beträgt der Wellenlängenunterschied mindestens 3%. Dies hat den Vorteil, dass einerseits eine ausreichende Leistungssteigerung ermöglicht wird und dass andererseits die Mehrzahl von Lichtquellen in einem optimalen Wellenlängenbereich angeordnet sind.

Gemäß einer weiteren bevorzugten Ausbildungsform der Erfindung sind die Lichtquellen als UV-Hochleistungsleuchtdioden ausgebildet.

Nach einer weiteren bevorzugten Ausführungsform der Erfindung weist die erste Lichtquelle eine Wellenlänge von 365 nm, die zweite Lichtquelle eine Wellenlänge von 390 nm und die dritte Lichtquelle eine Wellenlänge von 405 nm auf. Durch das Zusammenfassen von drei LEDs wird die Lichtenergie und damit die Leistung des Direktbelichters erhöht. Während die Wellenlänge von 365 nm besser für Trockenfilme geeignet ist, ist für Lötstoplacke die dritte Lichtquelle mit einer Wellenlänge von 405 nm besser geeignet. Die Wellenlängen der drei Lichtquellen befinden sich zum einen in einem optimalen Wellenlängenbereich und zum anderen weisen sie untereinander ausreichende Wellenlängendifferenzen auf, die eine Leistungssteigerung mit dem Beam-Combiner erst ermöglichen.

Gemäß einer weiteren bevorzugten Ausführungsform der Erfindung sind die Lichtquellen von einer Steuer- und Regeleinheit einzelnen zu- und abschaltbar. Dies ist insbesondere für eine selektive Belichtung von bestimmten Materialien günstig.

Nach einer weiteren bevorzugten Ausführungsform der Erfindung ist der Lichtmodulator als ein Mikrospiegel ausgebildet. Die Beam-Combiner sind insbesondere im Hinblick auf ihre Beschichtung auf die Wellenlängen der Lichtquellen abgestimmt.

Die Beam-Combiner sind als dichroitische Spiegel ausgebildet, die auf die Wellenlängen der Lichtquellen abgestimmt sind

Weitere Einzelheiten der Erfindung ergeben sich aus der nachfolgenden ausführlichen Beschreibung und den beigefügten Zeichnungen, in denen bevorzugte Ausführungsformen der Erfindung beispielhaft veranschaulicht sind.

### Kurzbeschreibung der Zeichnungen

In den Zeichnungen zeigen:

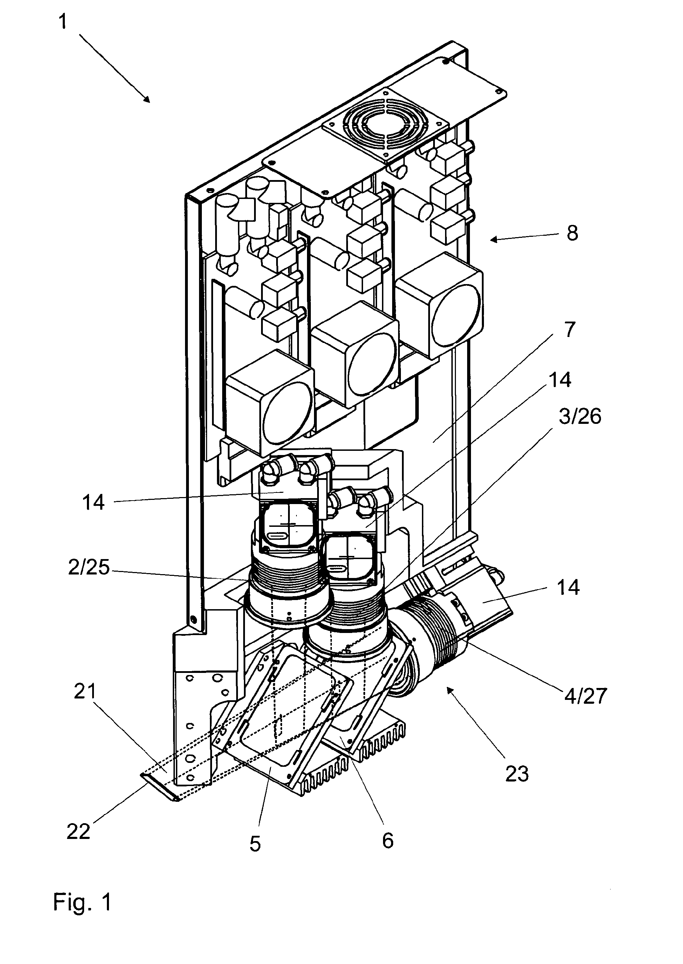

- Figur 1:: eine räumliche Darstellung einer Belichtungsanordnung mit einem vorgelagerten räumlichen Lichtmodulator,

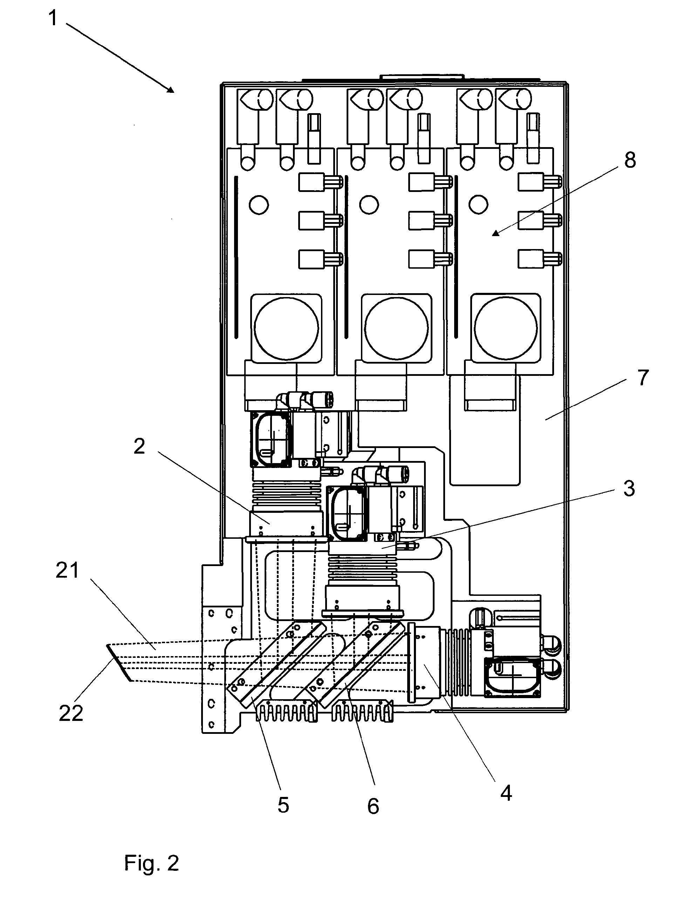

- Figur 2:: eine Seitenansicht der Belichtungsanordnung von Figur 1,

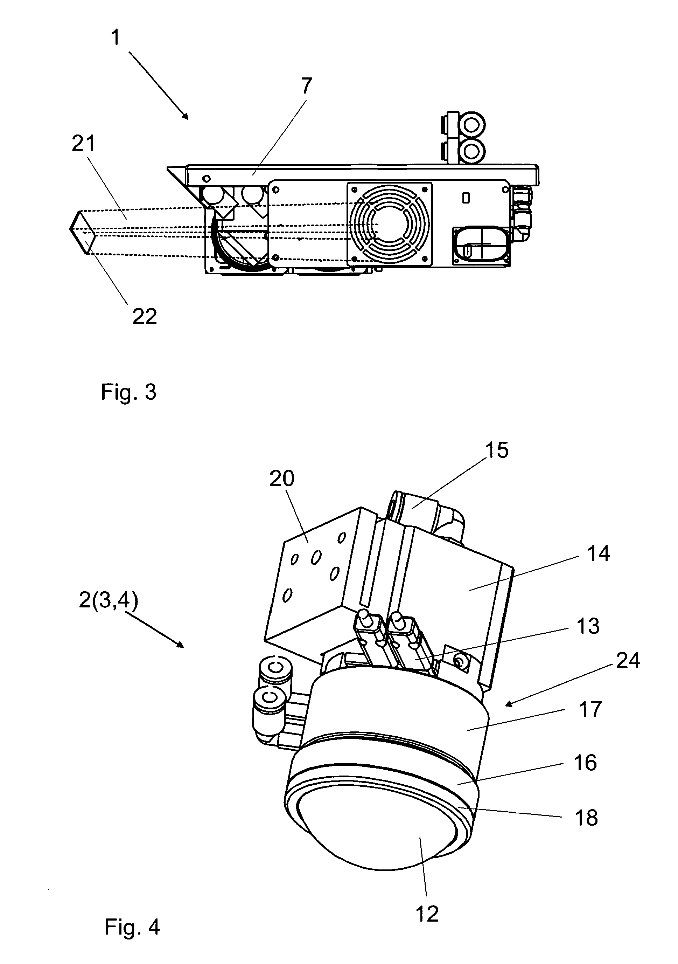

- Figur 3:: eine Draufsicht auf die Belichtungsanordnung von Figur 2,
- Figur 4:: eine räumliche Darstellung eines Leuchtenkopfes entsprechend der Figuren 1 bis 3,

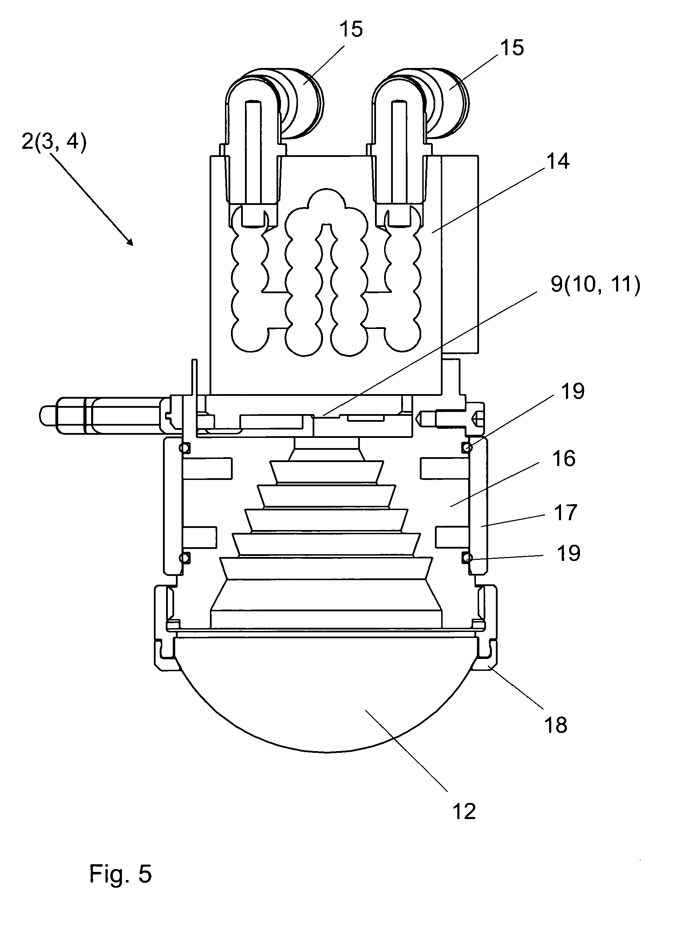

- Figur 5:: eine Seitenansicht im Schnitt des Leuchtenkopfes von Figur 4 in vergrößerter Darstellung und

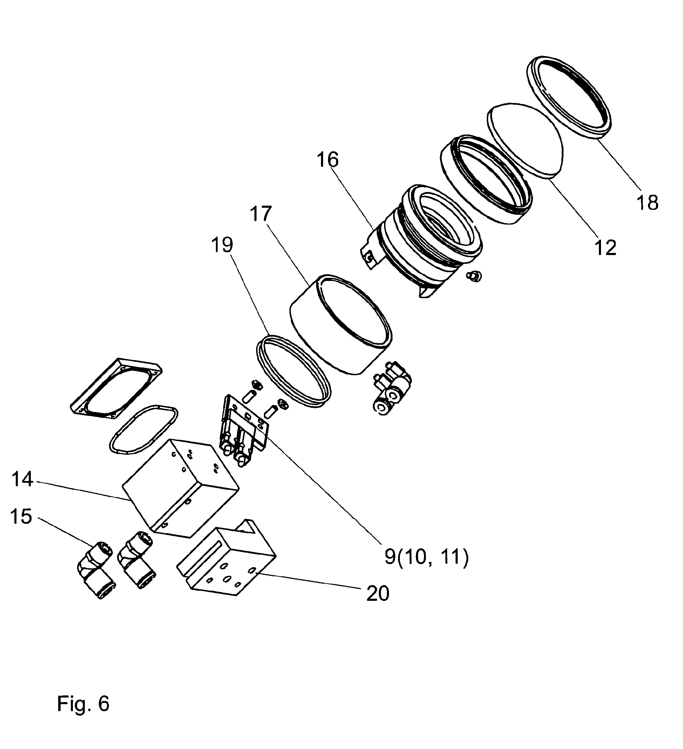

- Figur 6:: eine Explosionsdarstellung des Leuchtenkopfes von Figur 4.

### Beschreibung der Ausführungsbeispiele

Eine Beleuchtungsanordnung 1 besteht im Wesentlichen aus drei Leuchtenköpfen 2, 3, 4 und zwei Beam-Combinern 4, 5.

Die Beleuchtungsanordnung 1 weist eine Grundplatte 7 auf, an der neben einer Steuer- und Versorgungselektronik 8 die Leuchtenköpfe 2, 3, 4 und die Beam-Combiner 5, 6 angeordnet sind.

Im Ausführungsbeispiel sind der erste Leuchtenkopf 2 und der zweiten Leuchtenkopf 3 mit ihren Längsachsen in vertikaler Richtung parallel nebeneinander angeordnet. Entsprechend der sich ergebenen Strahlengeometrie ist der erste Leuchtenkopf 2 gegenüber dem zweiten Leuchtenkopf 3 etwas zurückgesetzt.

Der dritte Leuchtenkopf 4 ist mit seiner Längsachse quer, im Ausführungsbeispiel also horizontal, zu den anderen Leuchtenköpfen 2, 3 angeordnet. Dem ersten Leuchtenkopf 2 ist der erste Beam-Combiner 5 und dem zweiten Leuchtenkopf 3 ist der zweite Beam-Combiner 6 zugeordnet. Die Beam-Combiner (5, 6) sind als dichroitische Spiegel ausgebildet, die auf die Wellenlängen der Lichtquellen (25, 26, 27) abgestimmt sind

Die Leuchtenköpfe 2, 3, 4 bestehen im Wesentlichen jeweils aus einer UV-Leuchtdiode 9, 10, 11 und einer der Leuchtdiode vorgelagerten Sammellinse 12. Die Leuchtdioden 9, 10, 11 sind mit einem Diodenträger 13 jeweils an einem Kühlkörper 14 befestigt. Der Kühlkörper 14 weist zwei Kühlkörperanschlüsse 15 zum Anschluss an einen nicht dargestellten Kühlkreislauf auf.

Ein Linsenhalter 16 ist mit einer Dichthülse 17 an dem Kühlkörper 14 mit UV-Leuchtdiode 9, 10, 11 aufsetzbar. Dabei wird die Sammellinse 12 über einen Linsenring 18 in dem Linsenhalter 16 fixiert. Über O-Ringe 19 wird der Linsenhalter 16 von der Dichthülse 17 abgedichtet.

Am Kühlkörper 14 ist seitlich ein Ausrichtsockel 20 angeordnet, über den der Leuchtenkopf 2, 3, 4 gegenüber der Grundplatte 7 ausrichtbar ist.

Im kombinierten Strahlengang 21 der drei Leuchtenköpfe 2, 3, 4 ist der Grundplatte 7 ein Lichtmodulator 22 zur vorbestimmbaren Reflexion des kombinierten Strahlenganges 21 angeordnet.

Die Leuchtenköpfe 2, 3, 4 bilden eine Leuchte 23, die den kombinierten Strahlengang 21 aufweist.

Kühlkörper 14, Linsenhalter 16 und Dichthülse 17 bilden im Wesentlichen das Gehäuse 24 der Leuchtenköpfe 2, 3, 4.

Die Leuchtdioden 9, 10, 11 sind als UV-Hochleistungsleuchtdioden ausgebildet. Die erste Leuchtdiode 9 des ersten Leuchtenkopfes 2 emittiert Licht mit einer Wellenlänge von 365 nm und bildet eine erste Lichtquelle 25 der Leuchte 23. Die zweite Leuchtdiode 10 emittiert Licht einer Wellenlänge von 390 nm und bildet eine zweite Lichtquelle 26 der Leuchte 23. Die dritte Leuchtdiode 11 des dritten Leuchtenkopfes 4 emittiert Licht mit einer Wellenlänge von 405 nm und bildet eine dritte Lichtquelle 27 der Leuchte 23.

Die Beam-Combiner 5, 6 sind ebenfalls an der Grundplatte 7 angeordnet. Dem dritten Leuchtenkopf 4 vorgelagert ist der zweite Beam-Combiner 6. Der zweite Beam-Combiner 6 lässt den Strahlengang des dritten Leuchtenkopfes 4 ungehindert hindurch. Der Strahlengang des zweiten Leuchtenkopfes 3 wird von dem zweiten Bean-Combiner 6 so abgelenkt, dass er mit dem Strahlengang der dritten Leuchtenkopfes 4 zusammenfällt.

Der kombinierte Strahlengang der Leuchtenköpfe 3, 4 wird ungehindert durch den ersten Beam-Combiner 5 hindurchgeführt, während der Strahlengang des ersten Leuchtenkopfes 2 von dem ersten Beam-Combiner so abgelenkt wird, dass er mit dem kombinierten Strahlengang der Leuchtenköpfe 3, 4 zusammenfällt und den kombinierten Strahlengang 21 und damit den Strahlengang der Leuchte 23 bildet.

Natürlich stellen die in der speziellen Beschreibung diskutierten und in den Figuren gezeigten Ausführungsformen nur illustrative Ausführungsbeispiele der vorliegenden Erfindung dar. Dem Fachmann ist im Lichte der hiesigen Offenbarung ein breites Spektrum an Variationsmöglichkeiten an die Hand gegeben.

### Bezugszeichenliste

- 1: Beleuchtungsanordnung
- 2: erster Leuchtenkopf
- 3: zweiter Leuchtenkopf
- 4: dritter Leuchtenkopf
- 5: erster Beam-Combiner
- 6: zweiter Beam-Combiner
- 7: Grundplatte
- 8: Steuer- und Versorgungselektronik
- 9: UV-Leuchtdiode von 2
- 10: UV-Leuchtdiode von 3
- 11: UV-Leuchtdiode von 4
- 12: Sammellinse
- 13: Diodenträger
- 14: Kühlkörper
- 15: Kühlkörperanschluss
- 16: Linsenhalter
- 17: Dichthülse
- 18: Linsenring
- 19: O-Ring
- 20: Ausrichtsockel
- 21: kombinierter Strahlengang
- 22: Lichtmodulator
- 23: Leuchte
- 24: Gehäuse
- 25: erste Lichtquelle
- 26: zweite Lichtquelle
- 27: dritte Lichtquelle

## Patentansprüche

1. Belichtungsanordnung (1) für eine Vorrichtung zur digitalen Direktbelichtung von elektronischen Leiterplatten mit einer Leuchte (23), deren Strahlen von einer Linse (12) gesammelt und einem vorgelagerten räumlichen Lichtmodulator (22) zum Reflektieren von Lichtstrahlen der Leuchte (23) in einem vorbestimmten Muster zugeführt werden,
**dadurch gekennzeichnet,**
**dass** die Leuchte (23) von mindestens zwei Lichtquellen (25, 26, 27), die als UV-Leuchtdioden (9, 10, 11) ausgebildet sind und unterschiedliche nahe beieinander liegende Wellenlängen aufweisen, gebildet wird,
**dass** die Wellenlängen benachbarter Lichtquellen (25, 26, 27) mindestens einen Wellenlängenunterschied von 2% aufweisen,
**dass** die mindestens zwei Lichtquellen (25, 26, 27) mit jeweils einer vorgelagerten Sammellinse (12) ausgebildet sind, deren Lichtstrahlen über einen Beam-Combiner (5, 6) zu einem gemeinsamen Strahlenbündel (21) verbunden und dem Lichtmodulator (22) zugeführt werden.

2. Belichtungsanordnung nach Anspruch 1,
**dadurch gekennzeichnet,**
**dass** die UV-Leuchtdiode (9, 19, 11) und die Sammellinse (12) zusammen mit einem Gehäuse (24) jeweils einen separaten Leuchtenkopf (2, 3, 4) bilden.

3. Belichtungsanordnung nach Anspruch 2,
**dadurch gekennzeichnet,**
**dass** die Leuchtenköpfe (2, 3, 4) flüssigkeitsgekühlt ausgebildet sind.

4. Belichtungsanordnung nach einem der Ansprüche 1 bis 3,
**dadurch gekennzeichnet,**
**dass** die Leuchte (23) von mindestens drei Lichtquellen (25, 26, 27) unterschiedlicher Wellenlänge gebildet wird.

5. Belichtungsanordnung nach einem der Ansprüche 1 bis 4,
**dadurch gekennzeichnet,**
**dass** der Wellenlängenunterschied mindestens 3% beträgt.

6. Belichtungsanordnung nach einem der Ansprüche 1 bis 5,
**dadurch gekennzeichnet,**
**dass** die Lichtquellen (25, 26, 27) als UV-Hochleistungsleuchtdioden ausgebildet sind.

7. Belichtungsanordnung nach einem der Ansprüche 1 bis 6,
**dadurch gekennzeichnet,**
**dass** die erste Lichtquelle (25) eine Wellenlänge von 365 nm, die zweite Lichtquelle (26) eine Wellenlänge von 390 nm und die dritte Lichtquelle (27) eine Wellenlänge von 405 nm aufweist.

8. Belichtungsanordnung nach einem der Ansprüche 1 bis 7,
**dadurch gekennzeichnet,**
**dass** die Lichtquellen (25, 26, 27) von einer Steuer- und Regeleinheit (8) einzeln zu- und abschaltbar sind.

9. Belichtungsanordnung nach einem der Ansprüche 1 bis 8,
**dadurch gekennzeichnet,**
**dass** der Lichtmodulator (22) als ein Mikrospiegel ausgebildet ist.

10. Belichtungsanordnung nach einem der Ansprüche 1 bis 10,
**dadurch gekennzeichnet,**
**dass** die Beam-Combiner (5, 6) auf die Wellenlängen der Lichtquellen (25, 26, 27) abgestimmt sind.
